(19) **Europäisches Patentamt**
**European Patent Office**
**Office européen des brevets**

(11) **EP 4 228 386 A1**

(12) **EUROPÄISCHE PATENTANMELDUNG**

(43) Veröffentlichungstag:
**16.08.2023   Patentblatt 2023/33**

(21) Anmeldenummer: **22155915.6**

(22) Anmeldetag: **09.02.2022**

(51) Internationale Patentklassifikation (IPC):
**H05K 13/08** (2006.01)

(52) Gemeinsame Patentklassifikation (CPC):
**H05K 13/085**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft
80333 München (DE)**

(72) Erfinder:
• **Pfaffinger, Alexander
81739 München (DE)**
• **Royer, Christian
85521 Ottobrunn (DE)**

(74) Vertreter: **Siemens Patent Attorneys
Postfach 22 16 34
80506 München (DE)**

(54) **COMPUTER-IMPLEMENTIERTES VERFAHREN ZUR BESTIMMUNG MINDESTENS EINER FESTRÜSTUNGS-RÜSTFAMILIE VON LEITERPLATTENTYPEN FÜR EINE VORGEGEBENE ANZAHL MEHRERER GRUPPEN VON EINER ODER MEHREREN BESTÜCKUNGSLINIEN**

(57)    Die Erfindung beansprucht ein Computer-implementiertes Verfahren zur Bestimmung mindestens einer Festrüstungs-Rüstfamilie von Leiterplattentypen (122) für eine vorgegebene Anzahl mehrerer Gruppen von einer oder mehreren Bestückungslinien (110), wobei eine Festrüstung (165) eine Menge an Bauelementtypen (160) umfasst, die zur Bestückung von Leiterplatten (120) einer der bestimmten Festrüstungs-Rüstfamilien von Leiterplattentypen ausreicht, wobei jede Festrüstung einer Festrüstungs-Rüstfamilie zugeordnet wird und während eines eine vorgegebene Anzahl von Bestückungsaufträgen umfassenden, vorgegebenen Planungshorizonts unverändert bleibt, und wobei jede Festrüstung an einer Bestückungslinie einer Gruppe eingesetzt wird, wobei das Verfahren folgende Schritte umfasst: a) Erfassen von Bestückungsaufträgen, welche jeweils eine Stückzahl von Leiterplatten eines Leiterplattentyps umfassen, wobei die Leiterplatten auf den einen oder mehreren Bestückungslinien innerhalb des Planungshorizont bestückt werden sollen, wobei jede Bestückungslinie zu einer Gruppe gehört; b) Zuordnen von Leiterplattentypen der erfassten Bestückungsaufträge an eine Festrüstungs-Rüstfamilie, wobei Leiterplattentypen einer vorgegebenen Menge an Leiterplattentypen nur einer oder mehreren bestimmten Festrüstungs-Rüstfamilien zugeordnet werden dürfen, deren Festrüstungen an einer oder mehreren Bestückungslinien lediglich einer Gruppe eingesetzt werden, mit dem Zweck, Leiterplatten aller zugeordneten Leiterplattentypen jeweils mit Hilfe der an den Bestückungslinien eingesetzten Festrüstungen, die zu den jeweiligen zugeordneten Festrüstungs-Rüstfamilien gehören, zu bestücken; c) Optimieren der Zuordnung aus Schritt b) derart, dass eine auf alle Gruppen bezogene Kennzahl optimiert, insbesondere maximiert, wird; d) Ausgeben der mittels der optimierten Zuordnung bestimmten Festrüstungs-Rüstfamilien in einer zur Steuerung und/oder zur Regelung der Bestückungsauftragserfüllung geeigneten Form.

FIG 2

**Beschreibung**

Die Erfindung betrifft ein Computer-implementiertes Verfahren zur Bestimmung mindestens einer Festrüstungs-Rüstfamilie von Leiterplattentypen für eine vorgebbare und/oder vorgegebene Anzahl mehrerer Gruppen von einer oder mehreren Bestückungslinien und eine Anordnung mit Datenverarbeitungssystem und Steuerungsvorrichtung sowie ein zugehöriges Computerprogrammprodukt.

Insbesondere im Bereich der Elektronikproduktion werden zu fertigende Leiterplatten bzw. Baugruppen auf SMT-Bestückungslinien durch Oberflächenmontage (SMT = surface mounted technology) hergestellt. Die Elektronikproduktion bzw. -fertigung ist geprägt durch hohe Anforderungen an kurze Durchlaufzeiten, hohe Produktivität (u.a. kurze Umrüstzeiten, kurze Produktionszeiten, usw.) und hohe Flexibilität.

Mehrere Bestückungsautomaten, die üblicherweise durch ein Transportsystem verbunden sind, und die z.B. zum Fertigen bzw. Bestücken von (Elektronik-)baugruppen zusammenwirken, stellen eine Bestückungslinie dar. Ein Bestückungssystem, das ein oder mehrere Bestückungslinien umfassen, bildet damit eine Gruppe von einer oder mehreren Bestückungslinien. Jede Gruppe kann hierbei in einer Produktionsstätte von einer vorgebbaren und/oder vorgegebenen Anzahl von unterschiedlichen Produktionsstätten angeordnet sein. Produktionsstätten können hierbei in unterschiedlichen Fertigungswerken oder im selben Fertigungswerk angeordnet sein. Mehrere Produktionsstätten sind in der Regel örtlich voneinander getrennt oder entfernt.

In den industriellen Fertigungswerken im Bereich der Elektronikproduktion werden zu fertigende Baugruppen (bzw. Leiterplatten) in Aufträgen mit fest vorgegebenen Losgrößen produziert.

Durch die Losgrößen wird implizit festgelegt, wie häufig eine Baugruppe zu produzieren ist. Je kleiner die Losgröße einer Baugruppe ist, umso häufiger muss diese Baugruppe produziert werden und umso größer sind die Rüstaufwände.

Die Erstellung einer (Bauelement-)Rüstung, auch Setup genannt, für eine Bestückungslinie benötigt ca. 6-8 Stunden und verursacht somit einen enormen Aufwand. Die Produktion der Baugruppen erfolgt somit in Rüstfamilien. Eine Rüstfamilie ist dabei eine Menge von Baugruppentypen, die mit einer Rüstung auf der Bestückungslinie produzierbar sind.

Mit anderen Worten ausgedrückt umfasst eine Rüstfamilie, auch Cluster genannt, eine Menge von Losen, die innerhalb einer Rüstung gefertigt werden kann. Alle Baugruppen der Baugruppentypen einer Rüstfamilie können also nacheinander ohne Umrüsten auf der Bestückungslinie gefertigt werden.

Eine Rüstung kann auf einem oder mehreren Rüsttischen gehalten werden, die leicht am Bestückungsautomaten ausgewechselt werden können. Ein Aufrüsten eines Rüsttischs mit Bauelementen von vorbestimmten Bauelementtypen ist jedoch aufwändig. Die Rüstungen werden daher oft in Festrüstungen und Variantenrüstungen unterschieden, wobei eine Festrüstung auf einem Rüsttisch dazu vorgesehen ist, seine Zusammensetzung von Bauelementtypen über einen vorbestimmten Planungshorizont zu behalten, während ein Variantenrüsttisch voraussichtlich innerhalb des Planungshorizonts umgerüstet wird.

Aus EP 2 893 791 B1 ist ein Verfahren zur Bestimmung einer möglichst vorteilhaften Festrüstung für eine Bestückungslinie bekannt. Dieses Verfahren berücksichtigt jedoch nicht, dass mehrere Bestückungslinien eines Bestückungssystems idealerweise in ihren zugeordneten Leiterplattentypen aufeinander abgestimmt werden sollten, um die parallele Produktion von Leiterplatten unterschiedlicher Leiterplattentypen möglichst effizient zu gestalten.

In EP 3 219 180 B1 wird das Problem aus EP 2 893 791 B1 für mehrere Bestückungslinien eines Bestückungssystems gelöst. Dieses Verfahren ist auf eine einzige Gruppe von Bestückungslinien innerhalb einer Produktionsstätte gerichtet.

Heutzutage erfolgt die Elektronik-Produktion häufig in weltweiten Fertigungswerksverbünden, in denen es häufig zu Produktverlagerungen unter den Produktionsstätten in einem solchen Verbund kommt. Es muss immer wieder entschieden werden, welche Produkte mit welchen Baugruppentypen in welchen Produktionsstätten, auf welchen Bestückungslinien und mit welchen dort zu erstellenden Festrüstungen produziert werden sollen.

Die Aufgabe der Erfindung besteht darin, ein gegenüber des eingangs genannten Standes der Technik verbessertes Verfahren sowie ein verbessertes System bzw. eine verbesserte Vorrichtung und Anordnung, die zur Durchführung des Verfahrens geeignet sind, anzugeben.

Diese Aufgabe wird durch die unabhängigen Ansprüche gelöst. Vorteilhafte Weiterbildungen sind Gegenstand der abhängigen Ansprüche.

Die Erfindung beansprucht ein computer-implementiertes Verfahren zur Bestimmung mindestens einer Festrüstungs-Rüstfamilie von Leiterplattentypen für eine vorgegebene Anzahl mehrerer Gruppen von einer oder mehreren Bestückungslinien, wobei eine Festrüstung eine Menge an Bauelementtypen umfasst, die zur Bestückung bzw. Fertigung von Leiterplatten einer der bestimmten Festrüstungs-Rüstfamilien von Leiterplattentypen ausreicht, wobei jede Festrüstung einer Festrüstungs-Rüstfamilie zugeordnet wird und während eines eine vorgegebene Anzahl von Bestückungsaufträgen umfassenden, vorgegebenen Planungshorizonts unverändert bleibt, und wobei jede Festrüstung an einer Bestückungslinie einer Gruppe eingesetzt wird, wobei das Verfahren folgende Schritte umfasst:

a) Erfassen von Bestückungsaufträgen, welche jeweils eine Stückzahl von Leiterplatten eines Leiterplattentyps umfassen, wobei die Leiterplatten auf den einen oder mehreren Bestückungslinien innerhalb des Planungshorizont bestückt werden sollen, wobei jede Bestückungslinie zu einer Gruppe gehört;

b) Zuordnen von Leiterplattentypen der erfassten Bestückungsaufträge an eine Festrüstungs-Rüstfamilie, wobei Leiterplattentypen einer vorgegebenen Menge an Leiterplattentypen nur einer oder mehreren bestimmten Festrüstungs-Rüstfamilien zugeordnet werden dürfen, deren Festrüstungen an einer oder mehreren Bestückungslinien lediglich einer Gruppe eingesetzt werden, mit dem Zweck, Leiterplatten aller zugeordneten Leiterplattentypen jeweils mit Hilfe der an den Bestückungslinien eingesetzten Festrüstungen, die zu den jeweiligen zugeordneten Festrüstungs-Rüstfamilien gehören, zu bestücken bzw. zu fertigen;

c) Optimieren der Zuordnung aus Schritt b) derart, dass eine auf alle Gruppen bezogene Kennzahl optimiert, insbesondere maximiert, wird; und

d) Ausgeben der mittels der optimierten Zuordnung bestimmten Festrüstungs-Rüstfamilien in einer zur Steuerung und/oder zur Regelung der Bestückungsauftragserfüllung geeigneten Form.

Es ist möglich, dass nicht alle Leiterplattentypen einer Festrüstungs-Rüstfamilie zugeordnet werden.

Die Leiterplatten der Leiterplattentypen, die zur vorgegebenen Menge gehören, können demnach nicht auf beliebigen Bestückungslinien in beliebigen Gruppen sondern lediglich auf der einen oder mehreren Bestückungslinie(n) lediglich einer Gruppe bestückt werden.

Mit anderen Worten ausgedrückt, werden alle Leiterplattentypen dieser vorgegebenen Menge nur einer oder mehreren bestimmten Festrüstungs-Rüstfamilien zugeordnet. Die bestimmten Festrüstungs-Rüstfamilien, denen die Leiterplattentypen der vorgegebenen Menge zugeordnet werden, führen dazu, dass diese Leiterplattentypen auf einer oder mehreren Bestückungslinien derselben Gruppe zu deren Bestückung landen.

Die Leiterplatten der verbleibenden Leiterplattentypen, die nicht zu der vorgegebenen Menge gehören, können auf beliebigen Bestückungslinien in beliebigen Gruppen bestückt werden.

Zweckmäßigerweise wird eine Menge an zulässigen Bestückungslinien vorgegeben, denen ein bestimmter Leiterplattentyp zugeordnet werden darf.

Ein Bestückungsauftrag umfasst eine Stückzahl bzw. Menge von Leiterplatten eines Leiterplattentyps.

Eine Festrüstung wird durch Bereitstellen von Vorräten von Bauelementen der von ihr umfassten Bauelementtypen auf einem oder mehreren Rüsttischen gebildet. Erfindungsgemäß ist eine Menge von zu bildenden bzw. zu bestimmenden Festrüstungs-Rüstfamilien vorgegeben, denen mittels des beschriebenen Verfahrens Leiterplattentypen zugeordnet werden. Dabei kann eine Optimierung der Zuordnung von Leiterplattentypen zu den vorgegebenen Festrüstungs-Rüstfamilien für mehrere Gruppen gleichzeitig erfolgen.

Das obige Verfahren kann beliebig oft iteriert werden.

Die Bestimmung mindestens einer Festrüstungs-Rüstfamilie von Leiterplattentypen kann mit den Schritten a) bis d) zentral auf einem Datenverarbeitungssystem vorzugsweise der nachstehend beschriebenen Art ausgeführt werden.

Die zur Steuerung bzw. zur Regelung der Bestückungsauftragserfüllung und der damit verbundenen, zur Steuerung der Bestückung der Leiterplatten geeignete Form ist vorzugsweise computerlesbar. Mit der Steuerung bzw. Regelung der Bestückung der Leiterplatten, die entsprechenden Leiterplattentypen zugeordnet sind, wird die Bestückung der Leiterplatten letztendlich ausgeführt.

Mit Hilfe der Festrüstung innerhalb einer Gruppe von einer oder mehreren Bestückungslinien anhand der bestimmten Festrüstungs-Rüstfamilien in genannter Form kann die Bestückung von Leiterplatten gesteuert und/oder geregelt und/oder zur Ausführung gebracht werden. Dabei ergibt sich die Festrüstung aus einer entsprechenden Festrüstungs-Rüstfamilie der bestimmten Festrüstungs-Rüstfamilien, der die Leiterplattentypen der zu bestückenden Leiterplatten zugeordnet werden/sind.

Die oben genannte Kennzahl kann eine Anzahl an Bestückungsaufträgen ausdrücken, deren Leiterplattentypen einer Festrüstungs-Rüstfamilie zugeordnet werden.

Es ist zweckmäßig, eine Menge der zulässigen Bestückungslinien für einen Leiterplattentyp vorzugeben. Damit ergibt sich auch, welcher Leiterplattentyp an einer Bestückungslinie innerhalb welcher Gruppe gefertigt werden kann. Jede Gruppe mit einer vorgegebenen oder vorgebbaren Anzahl von Bestückungslinien ist vorzugsweise in einer Produktionsstätte von einer vorgegebenen oder vorgebbaren Anzahl von unterschiedlichen Produktionsstätten angeordnet.

Es wird zudem ein Wert für einen Verlagerungsaufwand erfasst. Ein Verlagerungsaufwand tritt für den Transport einer oder mehrerer Leiterplatten eines Leiterplattentyps von einer Bestückungslinie einer Gruppe zu einer anderen Bestückungslinie einer anderen Gruppe ein, wenn der Leiterplattentyp einer Festrüstungs-Rüstfamilie der anderen Gruppe zugeordnet werden soll. Der Verlagerungsaufwand kann zusätzlich und/oder alternativ den Aufwand für den Transport von Bauelementen umfassen, die zur Bestückung des zu verlagernden Leiterplattentyp oder der mehreren zu verlagernden Leiterplattentypen in der Festrüstung der anderen Gruppe gebraucht werden.

Die genannte Kennzahl kann sich aus einer gewichteten Kombination der Anzahl an Bestückungsaufträgen sowie aus dem Gesamtwert über die Werte der Verlagerungsaufwände, die sich aus dem Zuordnen der Leiterplattentypen ergeben, berechnet werden.

Zusätzlich kann in die gewichtete Kombination eine Gesamtproduktionszeit der zugeordneten Leiterplattentypen eingehen, die sich aus erfassten Produktionszeiten für die Bestückung jeder Leiterplatte eines Leiterplattentyps auf einer Bestückungslinie einer Gruppe ergibt. Mit anderen Worten ausgedrückt, soll die Gesamtproduktionszeit der zugeordneten Leiterplattentypen möglichst minimiert und die Gesamtzahl der Bestückungsaufträge der zugeordneten Leiterplattentypen möglichst maximiert werden. Die Verlagerungsaufwände sollen möglichst geringgehalten werden.

Beim obigen computer-implementierten Verfahren kann unter "vorgegeben" bzw. "vorgebbar" verstanden werden, dass ein oder mehrere Eingabewerte bereits, beispielsweise durch Standard(werte), festgelegt sind oder von einem Benutzer und/oder durch Ausgabewerte eines vorgeschalteten computerimplementierten Verfahrens vorgegeben bzw. festgelegt werden und/oder vorgebbar bzw. festlegbar sind. Damit werden diese Eingabewerte vom computer-implementierten Verfahren erfasst.

In einer besonders bevorzugten Ausführungsform erfolgt das Optimieren mittels Gemischt Ganzzahliger Programmierung. Die Gemischt Ganzzahlige Programmierung stellt einen globalen Optimierungsansatz dar, der leicht erweiterbar ist und für die kommerzielle Lösungsverfahren bzw. Lösungsvorrichtungen, auch Solver genannt, erhältlich sind. Mittels Gemischt Ganzzahliger Programmierung können in einer Vielzahl möglicher Lösungen globale Maxima gefunden werden, so dass eine besonders gute Lösung gefunden werden kann. Erhältliche Verfahren bzw. Vorrichtungen zur Gemischt Ganzzahligen Programmierung werden laufend verbessert, sodass zu erwarten ist, dass zukünftig noch bessere Optimierungsergebnisse erzielbar sein werden.

Es kann ein Maß vorbestimmt sein bzw. werden, das einen Anteil an einem Unterschied zwischen der Kennzahl und einer maximal erreichbaren Zuordnungsgüte ausdrückt. Dieser Unterschied wird auch "Gap" genannt. Es wird bevorzugt, ein Optimierungsverfahren zu verwenden, bei dem dieser "Gap" bestimmt werden kann. Das kann insbesondere mit der Gemischt Ganzzahlige Programmierung erreicht werden.

Aus der erfindungsgemäßen optimierten Zuordnung von Leiterplattentypen zu Festrüstungs-Rüstfamilien resultiert eine Produktivitätssteigerung in den Produktionsstätten, indem

- Rüstaufwand deutlich reduziert wird
- (längerfristig) der Bedarf an Rüstequipment reduziert wird,
- die Produktivität durch kürzere Durchlaufzeiten, kürzere Umrüstzeiten und Produktionszeiten erhöht wird.
- Flexibilität, Durchsatz, Liefertreue werden erhöht
- Übergreifende Optimierungen über mehrere Produktionsstätten hinweg wird mit der Erfindung erst ermöglicht.

Ein weiterer Aspekt der Erfindung sieht ein Datenverarbeitungssystem umfassend mindestens eine Recheneinheit bzw. Prozessor, die dazu konfiguriert ist, ein computer-implementierte Verfahren zur Bestimmung mindestens einer Festrüstungs-Rüstfamilie von Leiterplattentypen für eine vorgegebene Anzahl mehrerer Gruppen von einer oder mehreren Bestückungslinien auszuführen, wobei eine Festrüstung eine Menge an Bauelementtypen umfasst, die zur Bestückung von Leiterplatten einer der bestimmten Festrüstungs-Rüstfamilien von Leiterplattentypen ausreicht, wobei jede Festrüstung einer Festrüstungs-Rüstfamilie zugeordnet wird und während eines eine vorgegebene Anzahl von Bestückungsaufträgen umfassenden, vorgegebenen Planungshorizonts unverändert bleibt, und wobei jede Festrüstung an einer Bestückungslinie einer Gruppe eingesetzt wird, umfassend zumindest:

a) eine Erfassungseinheit zum Erfassen von Bestückungsaufträgen, welche jeweils eine Stückzahl von Leiterplatten eines Leiterplattentyps umfassen, wobei die Leiterplatten auf den einen oder mehreren Bestückungslinien innerhalb des Planungshorizont bestückt werden sollen, wobei jede Bestückungslinie zu einer Gruppe gehört;

b) eine Zuordnungseinheit von Leiterplattentypen der erfassten Bestückungsaufträge an eine Festrüstungs-Rüstfamilie, wobei Leiterplattentypen einer vorgegebenen Menge an Leiterplattentypen nur einer oder mehreren bestimmten Festrüstungs-Rüstfamilien zugeordnet werden dürfen, deren Festrüstungen an einer oder mehreren Bestückungslinien lediglich einer Gruppe eingesetzt werden, mit dem Zweck, Leiterplatten aller zugeordneten Leiterplattentypen jeweils mit Hilfe der an den Bestückungslinien eingesetzten Festrüstungen, die zu den jeweiligen zugeordneten Festrüstungs-Rüstfamilien gehören, zu bestücken;

c) eine Optimierungseinheit zum Optimieren der Zuordnung derart, dass eine auf alle Gruppen bezogene Kennzahl optimiert, insbesondere maximiert, wird; und

d) eine Ausgabeeinheit zum Ausgeben der mittels der optimierten Zuordnung bestimmten Festrüstungs-Rüstfamilien in einer zur Steuerung und/oder zur Regelung der Bestückungsauftragserfüllung geeigneten Form.

Ein weiterer Aspekt sieht eine Steuerungsvorrichtung vor, umfassend wenigstens

- eine Empfangseinheit zum Empfangen von mittels optimierter Leiterplattentypen-Zuordnung bestimmten Festrüstungs-Rüstfamilien in einer zur Steuerung und/oder zur Regelung der Bestückungsauftragserfüllung geeigneten Form und

- eine Recheneinheit zum Verteilen der Leiterplattentypen auf eine oder mehrere Bestückungslinien, die gegebenenfalls zu unterschiedlichen Gruppen gehören, anhand der bestimmten Festrüstungs-Rüstfamilien, wobei Leiterplattentypen einer vorgegebenen Menge an Leiterplattentypen nur einer oder mehreren bestimmten Festrüstungs-Rüstfamilien zugeordnet werden dürfen, deren Festrüstungen an einer oder mehreren Bestückungslinien lediglich einer Gruppe eingesetzt werden, mit dem Zweck, Leiterplatten aller zugeordneten Leiterplattentypen jeweils mit Hilfe der an den Bestückungslinien eingesetzten Festrüstungen, die zu den jeweiligen zugeordneten Festrüstungs-Rüstfamilien gehören, zu bestücken.

Beansprucht wird ferner eine Anordnung umfassend ein Datenverarbeitungssystem und eine oder mehrere Steuerungsvorrichtungen der oben genannten Art, in der die Bestückung von Leiterplatten mit Hilfe der vom Datenverarbeitungssystem bestimmten mindestens einen Festrüstungs-Rüstfamilie an einer oder mehreren Bestückungslinien zur Ausführung gebracht werden kann. Es kann die Anzahl mehrerer Gruppen von einer oder mehreren Bestückungslinien vorgebbar und für jede Gruppe wenigstens eine Steuerungsvorrichtung zuständig oder in der Gruppe angeordnet sein. Es kann für mehrere Gruppen eine Steuerungsvorrichtung zentral für mehrere Bestückungslinien geben. Diese eine oder mehrere Steuerungsvorrichtung sind dabei mit dem Datenverarbeitungssystem verbunden. Es ist auch möglich, dass je eine Steuerungsvorrichtung pro Gruppe und mehrere Bestückungslinien bzw. eine Steuerungsvorrichtung pro Bestückungslinie in einer Gruppe vorgesehen ist. Bei einer dezentralen Lösung kommunizieren die mehreren Steuerungsvorrichtungen entsprechend untereinander über ein drahtgebundenes und/oder drahtloses Kommunikationsnetzwerk.

Die Anordnung bzw. das System bzw. die Vorrichtung und ggf. dazugehörige Einheit(en) sind dazu eingerichtet, solche Verfahrensschritte auszuführen, und können hardware-, firmware- und/oder softwaremäßig implementiert sein.

Ein weiterer Aspekt der Erfindung ist ein Computerprogramm(-produkt) umfassend einen durch eine Recheneinheit bzw. Prozessor ausführbaren Programmkode oder mehrere durch mehrere Recheneinheiten ausführbare und zusammenwirkende Programmkodemodule, welches oder welche Befehle aufweisen, die, die Ausführung des Verfahrens nach, einer der oben genannten Ausführungsformen auf dem Datenverarbeitungssystem der oben genannten Art und/oder in der Anordnung in der oben genannten Art veranlassen.

Das Computerprogramm bzw. -produkt kann auf einem computerlesbaren Speichermedium bzw. Datenträger gespeichert sein. Es ist möglich, dass das Computerprogramm(-produkt) in ein Datenträgersignal eingebunden ist, das für ein Herunterladen desselben von einem Server auf ein Speichermedium vorgesehen ist. Das Computerprogramm bzw. -produkt kann in einer üblichen Programmiersprache (z.B. C++, Java) erstellt sein. Eine Verarbeitungseinrichtung bzw. Prozessor für die Ausführung dessen Programmkodes/Programmkodemodule kann einen marktüblichen Computer oder Server mit entsprechenden Eingabe-, Ausgabe- und Speichermitteln umfassen. Diese Verarbeitungseinrichtung bzw. Recheneinheit kann im Datenverarbeitungssystem bzw. Vorrichtung bzw. in deren Einheiten integriert sein oder in der Anordnung bzw. den Anordnungskomponenten implementiert sein.

Das computer-implementierte Verfahren betrifft auch sogenannte Cloud-Dienste (Cloud = Rechnerwolke). Eine Rechnerwolke um fasst in der Regel ein oder mehrere Server, die von einem Cloud-Diensterbringers betrieben werden und dazu eingerichtet sind, einen Cloud-Dienst an einen Dienstnehmer z.B. einem Werkverbund zu liefern. Demnach kann Datenverarbeitungssystem in einer Rechnerwolke realisiert sein.

Die Anordnung, das Datenverarbeitungssystem und die Vorrichtungen sowie das Computerprogramm(-produkt) und Datenträger bzw. Datenträgersignal können analog zum oben genannten Verfahren und dessen Weiterbildungen weiter- bzw. ausgebildet sein.

Weitere Vorteile, Einzelheiten und Weiterbildungen der Erfindung ergeben sich aus der nachfolgenden Beschreibung von Ausführungsbeispielen in Verbindung mit den Zeichnungen.

Figur 1 zeigt beispielhaft ein Bestückungssystem,

Figur 2 zeigt ein Beispiel für die erfindungsgemäße Anordnung, in der mehrere Bestückungssysteme vorgesehen sind, und

Figur 3 zeigt ein Ablaufdiagramm des erfindungsgemäßen Verfahrens.

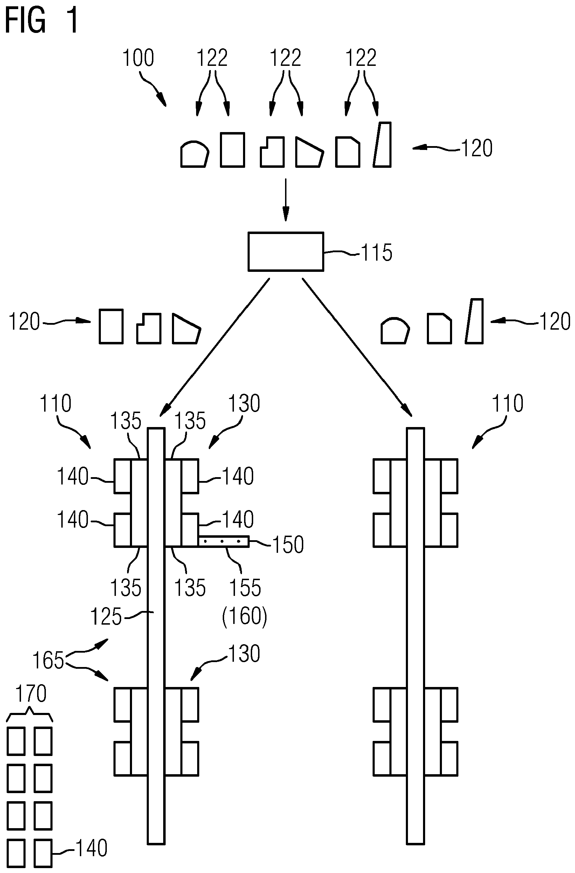

Figur 1 zeigt ein Bestückungssystem 100 einer Gruppe von einer oder mehreren Bestückungslinien. Das Bestückungssystem 100 umfasst eine oder mehrere Bestückungslinien 110 und eine Steuerungsvorrichtung 115. Jede Bestückungslinie 110 umfasst ein optionales Transportsystem 125 sowie einen oder mehrere Bestückungsautomaten 130. Jeder Bestückungsautomat 130 umfasst einen oder mehrere Bestückungsköpfe 135, die jeweils dazu eingerichtet sind, von einem Rüsttisch 140 Bauelemente bzw. -teile 155 aufzunehmen und an einer vorbestimmten Position auf der Baugruppe bzw. Leiterplatte 120 zu positionieren, die sich auf dem Transportsystem 125 befindet.

Während des Bestückungsvorgangs steht die Leiterplatte 120 bezüglich des Bestückungsautomaten 130 üblicherweise still. Die Rüsttische 140 umfassen jeweils eine Vielzahl Zuführungseinrichtungen 150, von denen in Figur 1 exemplarisch nur eine dargestellt ist. Jede Zuführungseinrichtung 150 hält einen Vorrat von Bauelementen 155 eines vorbestimmten Bauelementtyps 160 bereit. Für die Bauelemente 155 hat die Zuführungseinrichtung 150 ein Fassungsvermögen, das üblicherweise in Spuren ausgedrückt wird. Eine Spur ist üblicherweise 8 mm breit und die Zahl der Spuren jeder Zuführungseinrichtung 150 ist beschränkt, beispielsweise auf 40. Bauelemente 155 des gleichen Bauelementtyps 160 sind üblicherweise bereitgestellt in einem Gurt, auf einem Tablett oder in einer Röhre. Jeder Bauelementtyp 160 benötigt Platz in der Zuführungseinrichtung 150 mit einer vorbestimmten Anzahl an Spuren, die üblicherweise aneinander angrenzen müssen.

Jede Zuführungseinrichtung 150 kann zur Bereithaltung unterschiedlicher Bauelemente 155 konfiguriert werden und üblicherweise können unterschiedliche Zuführungseinrichtungen 150 an einem Rüsttisch 140 angebracht werden. Wird ein Bauelement 155 eines Bauelementtyps 160 am Bestückungsautomaten 130 benötigt, der nicht in einem der Rüsttische 140 vorhanden ist, so wird üblicherweise nicht einer der angebrachten Rüsttische 140 mit den benötigten Bauelementen 155 versehen, sondern komplett gegen einen anderen, entsprechend bestückten Rüsttisch 140 ausgetauscht. Das Aufrüsten eines einzuwechselnden Rüsttischs 140 mit Bauelementen 155 wird Vorrüstung genannt und kann eine Bearbeitungszeit im Stundenbereich erfordern.

Da ein Wechsel von Rüsttischen 140 an der Bestückungslinie 110 üblicherweise mit einem Produktionsstillstand verbunden ist, wird angestrebt, möglichst seltene Wechsel der Rüsttische 140 durchzuführen.

Ein Bestückungsauftrag umfasst die Stückzahl der zu bestückenden Leiterplatten eine Leiterplattentyps. Zur Bestückung einer anhand der Bestückungsaufträge vorbestimmbaren Menge von Leiterplatten 120 können Rüstungen gebildet sein, die jeweils Vorräte von Bauelementen 155 von vorbestimmten Bauelementtypen 160 umfassen, wobei jede Leiterplatte der Menge der Leiterplatten 120 mit Bauelementen 155 der Rüstung vollständig bestückt werden kann. Eine Rüstung kann realisiert sein durch eine Anzahl an Rüsttischen 140. In der Darstellung von Figur 1 sind eine Festrüstung 165, deren Rüsttische 140 an der Bestückungslinie 110 angebracht sind, und eine Variantenrüstung 170, deren Rüsttische 140 von der Bestückungslinie 110 getrennt sind, gebildet. Es können eine oder mehrere Festrüstungen 165 und eine oder mehrere Variantenrüstungen 170 vorgesehen sein. Ein angestrebter Fall ohne Variantenrüstungen 170 ist möglich.

Die Festrüstung 165 ist dazu eingerichtet, zumindest während eines Planungshorizonts, der beispielsweise ein halbes Jahr oder ein Jahr betragen kann, bezüglich seiner Bauelementtypen 160 unverändert bzw. bestehen zu bleiben. Es können also im Bedarfsfall zwar Bauelemente 155 an den Rüsttischen 140 der Festrüstung 165 nachgefüllt werden, die Zuordnung von Bauelementtypen 160 zu Spuren der Rüsttische 140 bleibt jedoch unverändert. Sind mehrere Festrüstungen 165 vorgesehen, so können diese innerhalb des Planungshorizonts gegeneinander ausgetauscht werden.

Eine Variantenrüstung 170 hingegen ist dazu eingerichtet, während des Planungshorizonts Bauelemente 155 unterschiedlicher Bauelementtypen 160 aufzunehmen, besteht aber nur temporär. Dazu werden üblicherweise die Rüsttische 170, während sie nicht an der Bestückungslinie 110 angebracht sind, von Bauelementen 155 vorbestimmter Bauelementtypen 160 abgerüstet und mit Bauelementen 155 anderer Bauelementtypen 160 aufgerüstet. Diese Umrüstung kann einen erheblichen Anteil manueller Arbeit umfassen und zeitaufwändig sein.

Eine Rüstfamilie, sei es eine Festrüstungs-Rüstfamilie bzw. Variantenrüstungs-Rüstfamilie, ist bestimmt als eine Menge von Leiterplattentypen, deren Leiterplatten auf einer Bestückungslinie bestückt werden können, ohne die Menge der Bauelementtypen zu ändern, die an der Bestückungslinie für die Bestückung bereitgehalten werden. D.h. es muss nicht umgerüstet werden.

Die Steuerungsvorrichtung 115 ordnet Leiterplattentypen 122, deren zugeordnete Leiterplatten 120 auf der Bestückungslinie 110 bestückt werden sollen, einer Rüstfamilie zu. Eine Rüstfamilie ist eine Menge von Leiterplattentypen 122, deren Leiterplatten 120 vollständig mit Bauelementen 155 bestückt werden können, die in der zugeordneten Rüstung 165, 170 bereitgestellt sind. Eine Rüstfamilie ist/wird üblicherweise genau einer Rüstung 165, 170 zugeordnet und umgekehrt.

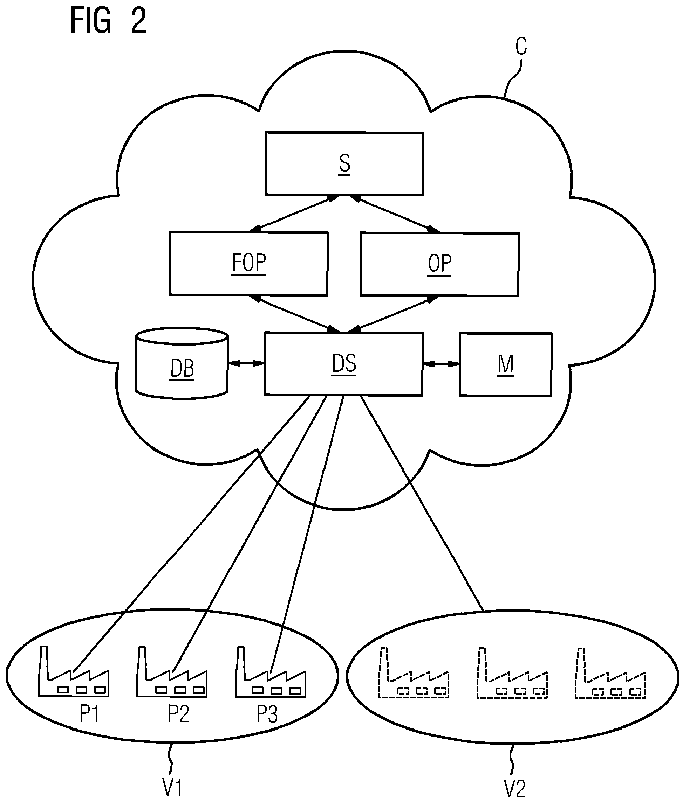

Figur 2 zeigt eine Anordnung, die die beispielsweise zwei (Fertigungs-)werkverbünde V1 und V2 der eingangs beschriebenen Art umfasst. Die Werksverbünde umfassen jeweils mehrere Produktionsstätten P1, P2 und P3. In einer Produktionsstätte können ein oder mehrere Bestückungslinien 110 der oben genannten Art für die Bestückung von Leiterplatten eingerichtet sein. Die Bestückungslinien in einer Produktionsstätte bilden im Kontext dieses Ausführungsbeispiels eine Gruppe von Bestückungslinien. Eine Gruppe von Bestückungslinien können aber auch noch kleinere Produktionszellen innerhalb einer Produktionsstätte sein, die in der Regel eine geringe Anzahl z.B. 2 oder 3 Bestückungslinien aufweisen. Eine nicht dargestellte zentrale Steuerungsvorrichtung oder mehrere Steuerungsvorrichtungen z.B. 115, die für eine oder mehrere Gruppe(n) von Bestückungslinien die Steuerung-/Regelung des Leiterplattenbestückungsprozesses auf den Bestückungslinien zur Erfüllung der Bestückungsaufträge eingerichtet ist/sind, kann/können jeweils mit einer Cloud bzw. Rechnerwolke C über drahtgebundene und/oder drahtlose Netzwerktechniken verbunden sein. Es ist auch möglich eine zentrale Steuerungsvorrichtung in die Rechnerwolke C zu integrieren, das in Figur 2 nicht dargestellt ist. Die Rechnerwolke kann mit folgenden Komponenten ausgestattet sein:

Ein Datenverarbeitungssystem DS bzw. -vorrichtung ist dazu geeignet, das nachfolgend noch näher erläuterte erfindungsgemäße computer-implementierte Verfahren zur Bestimmung mindestens einer Festrüstungs-Rüstfamilie von Leiterplattentypen für eine vorgebbare und/oder vorgegebene Anzahl mehrerer Gruppen von einer oder mehreren Bestückungslinien auszuführen. Das Datenverarbeitungssystem ist mit einem Datenspeicher DB gekoppelt und kann gespeicherte bzw. vorkonfigurierte Modelle M der Bestückungssysteme abrufen. In das Datenverarbeitungssystem können eine oder mehrere Optimierungseinheiten FOP oder OP integriert oder mit dieser gekoppelt sein, die wiederum mit sogenannten Solvern S, z.B. Cplex, Gurobi, gekoppelt sein können. Die Optimierungseinheiten können auch in FOP bzw. OP integriert sein. Solver (Löser) sind spezielle mathematische Computerprogramme, die mathematische Probleme numerisch lösen können. In der Optimierungseinheit FOP wird eine Zuordnung von Leiterplattentypen von erfassten Bestückungsaufträgen jeweils an eine Festrüstungs-Rüstfamilie optimiert. Mit den dadurch bestimmten Festrüstungs-Rüstfamilien werden die Festrüstungen, die in den Gruppen der Bestückungslinien zum Einsatz kommen sollen, festgelegt.

In der Optimierungseinheit OP könnte beispielsweise eine Optimierung der oben genannten Variantenrüstungs-Rüstfamilien bzw. damit verbunden Variantenrüstung erzielt werden.

Eine nicht dargestellte Ausgabeeinheit des Datenverarbeitungssystems liefert die bestimmten Festrüstungs-Rüstfamilien in einer zur Steuerung und/oder zur Regelung der Bestückungsauftragserfüllung geeigneten Form. Eine solche Form sollte computerlesebar sein z.B. ein oder mehrere Excellisten in CSV-Format, die die einzelnen Festrüstungs-Rüstfamilien mit ihren Leiterplattentypen enthält, wobei aus der Information aus dem Datenspeicher entnommen werden kann, welcher Leiterplattentyp auf welcher Bestückungslinie in welcher Gruppe gefertigt werden soll.

Anschließend kann bewertet werden, vorzugsweise mittels Simulation, welche Auswirkungen die bestimmte Festrüstungs-Rüstungsfamilien auf den Betrieb der einzelnen Bestückungslinien haben. Es kann zwar sein, dass eine optimale Kennzahl für die Bewertung erreicht wird, aber dann nicht vollständige Produktgruppen verlagert werden können. Vorzugsweise werden vollständige Produktgruppen, für deren Zusammensetzung bestimmte Leiterplattentypen gebraucht werden, auf eine gemeinsame Bestückungslinie in eine Produktionsstätte verlagert. Gegebenenfalls kann dann die Bestimmung der mindestens einen Festrüstungs-Rüstfamilie von Leiterplattentypen wiederholt werden.

Diese Excelliste(n) können dann jeweils an die in den Produktionsstätten angeordneten Steuerungsvorrichtungen zu deren Empfang gesendet werden. Eine nicht dargestellte Recheneinheit der Steuerungsvorrichtung kann dann die Steuerung und/oder Regelung einer Bestückung von Leiterplatten entsprechend der bestimmten Festrüstungs-Rüstfamilien vornehmen.

Zusätzlich und alternativ ist es möglich, dass die Steuerungsvorrichtung andere computerlesbare Steuerungssignale in Empfang nimmt, um daraus in ihre Recheneinheit den Steuerungs-/Regelungsprozess zu veranlassen.

Zusätzlich kann mit den bestimmten Festrüstungs-Rüstfamilien ein Verlagerungsprozess von bestimmten Leiterplatten eines Leiterplattentyps von einer Produktionsstätte in eine andere Produktionsstätte angestoßen werden.

Nach Abschluss der Bestimmung der Festrüstungs-Rüstfamilien und nach einer gegebenenfalls durchgeführten Verlagerung von zu Produktgruppen gehörenden Leiterplatten kann die Bestückung an der Bestückungslinien der entsprechenden Gruppe durchgeführt werden. Das Bestücken wird üblicherweise so durchgeführt, dass die Bauelemente 155 einzeln mittels Lötpaste an den Leiterplatten 120 fixiert werden. Anschließend können die bestückten Leiterplatten 155 in einem Reflow-Ofen fertig gestellt werden, in dem die Lötpaste vorübergehend aufgeschmolzen wird, sodass die Bauelemente 155 elektrisch und mechanisch mit Leiterbahnen an der Oberfläche der Leiterplatte 120 verbunden werden.

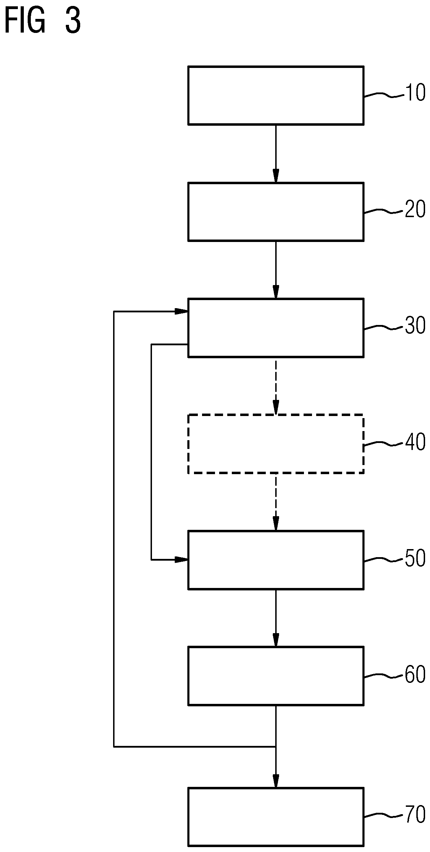

Figur 3 zeigt ein Ablaufdiagramm eines Verfahrens zur Bestimmung mindestens einer Festrüstungs-Rüstfamilie von Leiterplattentypen für eine vorgegebene Anzahl mehrerer Gruppen von einer oder mehreren Bestückungslinien gezeigt, umfassend folgende Schritte:

Im Schritt 10 wird die Anzahl der Gruppen, innerhalb derer jeweils mindestens eine Bestückungslinien, vorzugsweise mehrere Bestückungslinien angeordnet sind, vorgegeben. Diese Anzahl der Gruppen beträgt mindestens zwei. Die Anzahl der Bestückungslinien innerhalb einer Gruppe wird ebenfalls vorgegeben.

Pro Bestückungslinie ist die Anzahl der Festrüstungs-Rüstfamilien vorgegeben. Jede Festrüstung wird einer Festrüstungs-Rüstfamilie zugeordnet.

Im nächsten Schritt 20 können Informationen über die Bestückungsaufträge erfasst werden, die insbesondere zusammenfassender Natur sein können und beispielsweise eine Anzahl an Bestückungsaufträgen innerhalb eines Planungshorizonts oder eine Anzahl zu bestückender Leiterplatten eines Leiterplattentyps innerhalb des Planungshorizonts betreffen. Diese Informationen können insbesondere auf der Basis historischer Daten, die gegebenenfalls im Datenspeicher DB vorliegen oder mit einer Heuristik erfasst werden, die Daten gegebenenfalls aus einem Modell M heranzieht.

In Schritt 30 wird eine Art an Startlösung für eine Zuordnung der jeweiligen Leiterplattentypen zu einer Festrüstungs-Rüstfamilie bestimmt. Hierbei ist zu berücksichtigen, dass eine vorgegebene Menge der Leiterplattentypen nur einer Festrüstungs-Rüstfamilie zugeordnet werden dürfen, welche jeweils mit der ihr zugeordneten Festrüstung an einer oder mehreren Bestückungslinien innerhalb derselben Gruppe bzw. lediglich einer Gruppe eingesetzt wird. Die Leiterplatten der Leiterplattentypen, die zur vorgegebenen Menge gehören, können demnach nicht auf beliebigen Bestückungslinien in beliebigen Gruppen sondern lediglich auf der einen oder mehreren Bestückungslinie(n) lediglich einer Gruppe bestückt werden.

Es ist eine Menge an zulässigen Bestückungslinien vorgegeben, denen ein bestimmter Leiterplattentyp zugeordnet werden darf. Die Zuordnung kann noch weiter unter Berücksichtigung einer in Schritt 50 näher erläuterten Kennzahl optimiert werden.

Optional Schritt 40: Beim Zuordnen im Schritt 30 können verschiedene Nebenbedingungen zusätzlich berücksichtigt werden, die beispielsweise in der nachfolgenden Formulierung eines Gemischt ganzzahligen Programms näher beschrieben werden. Dieser Schritt 40 kann auch übersprungen werden, dann folgt nach Schritt 30 direkt Schritt 50.

Schritt 50: Eine Zuordnungsgüte der im Schritt 30 durchgeführten Zuordnung wird auf der Basis der im Schritt 20 erfassten Informationen und gegebenenfalls der im Schritt 10 vorgegebenen Gruppen bestimmt.

Zur Bestimmung der Zuordnungsgüte sind unterschiedliche Vorgehensweisen möglich, die auch miteinander kombinierbar sind. Es kann eine Kennzahl bestimmt werden, die der Zuordnungsgüte zu Grunde gelegt wird und die auf alle Gruppen bezogen ist.

Auf der Basis der Kennzahl, die im Folgenden berechnet wird, kann die obige Zuordnung derart optimiert werden, dass ein Optimum, vorzugsweise ein Maximum, dieser Kennzahl erreicht wird. Neben anderen oben im Allgemeinen Teil der vorliegenden Anmeldung genannten Ausführungsformen der Kennzahl, wird die Kennzahl im Ausführungsbeispiel bevorzugt wie folgt berechnet. Die Kennzahl kann aus einer gewichteten Kombination der Anzahl an Bestückungsaufträgen sowie aus dem Gesamtwert über die Werte der Verlagerungsaufwände und aus einer Gesamtproduktionszeit der zugeordneten Leiterplattentypen berechnet werden, die sich aus erfassten Produktionszeiten für die Bestückung jeder Leiterplatte eines Leiterplattentyps auf einer Bestückungslinie einer Gruppe ergibt. Ein solcher Wert drückt einen Verlagerungsaufwand für den Transport einer oder mehrerer Leiterplatten eines Leiterplattentyps von einer Bestückungslinie einer Gruppe zu einer anderen Bestückungslinie einer anderen Gruppe aus, wenn der Leiterplattentyp einer anderen Festrüstungs-Rüstfamilie der anderen Gruppe zugeordnet werden soll. Der Verlagerungsaufwand kann zusätzlich und/oder alternativ den Aufwand für den Transport von Bauelementen umfassen, die zur Bestückung des zu verlagernden Leiterplattentyp oder der mehreren zu verlagernden Leiterplattentypen in der Festrüstung der anderen Gruppe gebraucht werden. Eventuell müssen zusätzlich noch Rüstequipment wie Gurte und Rüsttische oder noch andere Sachen transportiert werden. Außerdem müssen in der neuen bzw. anderen Gruppe die neuen Leiterplattentypen in die Programme aufgenommen werden. D.h. es müssen eventuell neue CAD-Programme erstellt werden und Materialnummern angepasst werden. Hier entsteht also dann ein erheblicher Aufwand.

Schritt 60: Die bestimmte Zuordnungsgüte wird mit einem vorbestimmten Maß verglichen. Das vorbestimmte Maß kann absolut angegeben sein, beispielsweise in Form einer Zahl. Das Maß kann auch relativ angegeben sein, beispielsweise in Form eines Verhältnisses mehrerer solcher Angaben. In einer bevorzugten Ausführungsform ist das vorbestimmte Maß auf der Basis einer maximal erreichbaren Kennzahl angegeben. Fällt der Vergleich positiv aus, so wird die bestimmte Zuordnung bevorzugt in einer computerlesbaren Form - wie bereits oben zu Figur 2 bereits erläutert - in Schritt 70 ausgegeben. Fällt der Vergleich negativ aus, ist also die bestimmte Zuordnungsgüte kleiner als das vorbestimmt Maß, so kann in diesem Schritt optional geprüft werden, ob eine vorbestimmte Bearbeitungszeit zum Durchlaufen des Verfahrens bereits abgelaufen ist.

Ist dies der Fall, so wird das Verfahren abgebrochen und mit Schritt 70 fortgefahren. Es kann auch die Anzahl der Iterationen vorgegeben werden, nach deren Überschreitung, das Verfahren abgebrochen und mit Schritt 70 fortgefahren wird.

Anderenfalls fährt das Verfahren mit Schritt 30 fort, in dem die bestimmte Zuordnung bezüglich der Kennzahl optimiert wird.

Zuletzt wird in Schritt 70 das Ergebnis der bestimmten Festrüstungs-Rüstfamilien in einer zur Steuerung und/oder zur Regelung der Bestückungsauftragserfüllung geeigneten (bevorzugt computerlesbaren) Form ausgegeben.

Zur Bestimmung einer optimierten Zuordnung von Leiterplattentypen zu einer Festrüstungs-Rüstfamilie kann eine automatische Optimierung verwendet werden. Dabei können beliebige Optimierungsmethoden verwendet werden, beispielsweise auf der Basis von lokalen Suchverfahren oder metaheuristischen Algorithmen. Bei jedem Durchlauf der genannten Schritte wird die beste bislang bestimmte Zuordnung pseudo-zufällig oder nach einer Heuristik variiert, sodass sich veränderte Zuordnungen ergeben, von denen die mit der optimalen Zuordnungsgüte ausgewählt wird.

Ein Spezialfall von Optimierungsmethoden ist die lineare Optimierung. Sie befasst sich mit der Optimierung linearer Zielfunktionen über einer Menge, die durch lineare Gleichungen und Ungleichungen eingeschränkt ist. Sie ist Grundlage der Lösungsverfahren der (gemischt-) ganzzahligen linearen Optimierung. Im Zusammenhang mit MIP (mixed integer programming) bzw. MILP (gemischt ganzzahlige Lineare Programmierung) können für kleine IP-Programme (ganzzahlige Optimierungsmodelle) Standardsolver wie z.B. CPLEX, Scip, Gurobi, Xpress verwendet werden.

Schwieriger als die lineare Optimierung ist der Fall der nichtlinearen ganzzahliger Optimierung (MINLP), bei der die Zielfunktion, die Nebenbedingungen (NB) oder beide vorliegen können. Die Lösung wird erreicht, indem geeignete lineare Approximationen verwendet werden, so dass Standardsolver direkt verwendet werden können. Darüber hinaus können die oben genannten Standardsolver jeweils bestimmte Arten von nichtlinearen Problemen bereits lösen. Außerdem gibt es zusätzliche Solver, die auf die Lösung nichtlinearer Probleme spezialisiert sind (z.B. ANTIGONE, BARON).

Mit Hilfe von nichtlinearen ganzzahligen Optimierungsverfahren lassen sich Festrüstungs-Rüstfamilien ermitteln, mit denen eine auf alle Gruppen bezogene optimale bzw. maximale Kennzahl erzielt wird.

Bevorzugterweise erfolgen die Schritte 30 - 60 durch Lösen eines Gemischt Ganzzahligen Programms. Optimierer auf der Basis Gemischt Ganzzahliger Programmierungen sind - wie oben erläutert - als kommerzielle Produkte erhältlich.

Vorteile der Gemischt ganzzahligen linearen Optimierung sind:

- Globaler Optimierungsansatz.
- Leicht erweiterbar.
- Sehr gute kommerzielle Standard-Solver (z.B. Gurobi, SCIP, CPLEX, Ilog, Xpress), die in der Praxis weit verbreitet und bewährt sind.
- Für eine ermittelte Lösung ist bekannt, wie weit sie maximal von der optimalen Lösung entfernt ist (Gap).

Dabei wird im Beispiel als Optimierungskriterium eine auf alle Gruppen bezogenen Kennzahl möglichst maximiert. Diese kann eine gewichtete Kombination des vorgegebenen Produktionsvolumens und der erfassten Auftragszahl sowie erfassten Verlagerungsaufwände umfassen, wenn die Zuordnung der Leiterplattentypen ergibt, dass ein Leiterplattentyp einer Festrüstungs-Rüstfamilie einer anderen Gruppe zugeordnet werden soll.

Mit anderen Worten ausgedrückt, die Leiterplatten diesen Leiterplattentyps und gegebenenfalls auch Bauelemente werden von einer Produktionsstätte z.B. P1 in eine andere Produktionsstätte P3 verlagert. Dies verursacht Verlagerungsaufwand durch den Transport und durch mögliche Verzögerungen in der Fertigung.

Im Folgenden wir ein Beispiel für eine MIP-Formulierung zur Bestimmung der beschriebenen Zuordnung von Leiterplattentypen zu einer Festrüstungs-Rüstfamilie gegeben.

Indices

| | |
|---|---|
| $W$ | Menge der Werke |
| $L$ | Menge der Bestückungslinien |
| $L_w$ | Menge der Bestückungslinien der Produktionsstätte w |
| $C$ | Menge der Bauelementtypen |
| $R$ | Menge der Baugruppentypen |
| $R_c$ | Menge der Baugruppentypen mit Bauelementtyp c |
| $R_w$ | Menge der Baugruppentypen, die aktuell in der Produktionsstätte w produziert werden |
| $R_f$ | Menge der Baugruppentypen, die einer Festrüstung zugeordnet werden müssen |
| $R_g$ | Menge von Baugruppentypen, die nur in Festrüstungen derselben Produktionsstätte landen dürfen |
| $Cl$ | Menge der zu bildenden Festrüstungen/Festrüstungs-Rüstfamilien |
| $Cl_l$ | Menge der zu bildenden Festrüstungen/Festrüstungs-Rüstfamilien für Bestückungslinie l |
| $L_r$ | Menge der zulässigen Bestückungslinien für den Baugruppentyp r |

Parameter

| | |
|---|---|
| $W_P$ | Zielfunktionsgewichtung hinsichtlich Produktionszeit |
| $W_O$ | Zielfunktionsgewichtung hinsichtlich Bestückungsauftragsanzahl |
| $W_V$ | Zielfunktionsgewichtung hinsichtlich Verlagerungsaufwand |

| | |
|---|---|
| $Width_{c,\,l}$ | Platzverbrauch eines Bauelementtyps $c$ in einer Festrüstung der Bestückungslinie $l$ in Spuren |
| $LineCap_l$ | Anzahl der Spuren der Bauelementtypen, die in einer Festrüstung der Bestückungslinie $l$ Platz haben |

| | |
|---|---|
| $UpperTimeLimit_l$ | Obere Produktionszeitschranke für die Bestückungslinie l |
| $LowerTimeLimit_l$ | Untere Produktionszeitschranke für die Bestückungslinie l |
| $ProdTime_{r,l}$ | Produktionszeit einer Baugruppe des Baugruppentyps $r$ auf der Bestückungslinie $l$ |
| $CurrentProdTime_r$ | Aktuelle Produktionszeit einer Baugruppe des Baugruppentyps $r$ |
| $Order_r$ | Anzahl der Aufträge einer Baugruppe des Baugruppentyps $r$ |

*RelocationEffort$_{r,l}$*  Verlagerungsaufwand einer Baugruppe des Baugruppentyps r auf die andere (neue) Bestückungslinie *l*

Binärvariablen

assign$_{r,cl}$ Variable, die angibt, ob die Baugruppen des Baugruppentyps *r* der Festrüstfamilie *cl* zugeordnet werden. (In diesem Fall nimmt sie den Wert 1 an, anderenfalls den Wert 0)

setup$_{c,cl}$ Variable, die angibt ob der Bauelementtyp c in der Festrüstung der Festrüstungs-Rüstfamilie *cl* gerüstet werden muss. (In diesem Fall nimmt sie den Wert 1 an, anderenfalls den Wert 0)

Zielfunktion

$$Maximiere\; W_P \sum_{l \in L} \sum_{r \in R} \sum_{cl \in Cl_l} (-1)\; assign_{r,cl} \left(\text{ProdTime}_{r,l} - \text{CurrentProdTime}_r\right)$$

$$+ W_O \sum_{l \in L} \sum_{r \in R} \sum_{cl \in Cl_l} assign_{r,cl}\; \text{Order}_r$$

$$+ W_V \sum_{w \in W} \sum_{r \in R_w} \sum_{l \in L \backslash L_w} \sum_{cl \in Cl_l} (-1)\; assign_{r,cl}\; RelocationEffort_{r,l}$$

Nebenbedingungen:

(1) Jeder Baugruppentyp darf höchstens einer Festrüstungs-Rüstfamilie zugeordnet sein.

$$\sum_{cl \in Cl} \text{assign}_{r,cl} \leq 1 \quad\quad r \in R$$

(2) Die Bauelementtypen der Baugruppentypen einer Festrüstungs-Rüstfamilie passen in eine Rüstung der Bestückungslinie.

$$\sum_{c \in C} \text{Width}_c\; setup_{c,cl} \leq LineCap_l \quad\quad\quad l \in L, cl \in Cl_l$$

(3) Alle Bauelementtypen einer Festrüstungs-Rüstfamilie werden in der Festrüstung der Festrüstungs-Rüstfamilie gerüstet.

$$\sum_{r \in R_c} \text{assign}_{r,cl} \leq |R_c| setup_{c,cl} \quad\quad\quad c \in C, cl \in Cl$$

(4) Die Summe der Produktionszeiten der Baugruppentypen einer Bestückungslinie darf die obere Produktionszeit-schranke nicht überschreiten.

$$\sum_{cl \in Cl_l} \sum_{r \in R} assign_{r,cl} \text{ProdTime}_{r,l} \leq UpperTimeLimit_l \quad l \in L$$

(5) Die Summe der Produktionszeiten der Baugruppentypen einer Festrüstungs-Rüstfamilie darf die untere Produktionszeitschranke nicht unterschreiten.

$$\sum_{cl \in Cl_l} \sum_{r \in R} assign_{r,cl} \text{ProdTime}_{r,l} \geq LowerTimeLimit_l \quad l \in L$$

(6) Baugruppen dürfen nur auf Bestückungslinien zugeordnet werden, auf denen sie auch produzierbar sind.

$$assign_{r,cl} = 0 \quad r \in R, l \in L \backslash L_r, cl \in Cl_l$$

(7) Baugruppentypen, die einer Festrüstung zugeordnet werden müssen.

$$\sum_{cl \in Cl} assign_{r,cl} = 1 \quad r \in R_f$$

(8) Baugruppentypen, die nur in Festrüstungen derselben Produktionsstätte landen dürfen.

$$\sum_{l \in L_{w_1}} \sum_{cl_1 \in Cl_l} assign_{r_1,cl_1} + \sum_{l \in L_{w_2}} \sum_{cl_2 \in Cl_l} assign_{r_2,cl_2} \leq 1 \quad r_1, r_2 \in R_g, r_1 \neq r_2,$$

$$w_1, w_2 \in W, w_1 \neq w_2$$

(9) Variablenrestriktionen

$$assign_{r,cl} \in \{0,1\} \quad r \in R, cl \in Cl$$

$$setup_{c,cl} \in \{0,1\} \quad c \in C, cl \in Cl$$

MIP-basierte Heuristik

Gerade bei der Festrüstungsbildung über mehrere Produktionsstätten hinweg kann durch eine hohe Anzahl von zu bestimmenden Festrüstungs-Rüstfamilien und der damit zu bildenden Festrüstungen die Komplexität zum Lösen eines MIP-Modells selbst für sehr gute (Computerprogramm-)Solver wie Gurobi zu hoch sein. Deshalb wird zusätzlich ein heuristischer Lösungsansatz beschrieben, der auf dem exakten, ersten Lösungsansatz basiert.

Zusätzliche Parameter:

n    Anzahl der Iterationen
$n_f$    Anzahl der in jedem Iterationsschritt neu berechnenden Festrüstungs-Rüstfamilien

(1) -> Als Startlösung werden vorzugsweise leere Festrüstungs-Rüstfamilien gewählt.
(2) -> Es werden $n_f$ Festrüstungs-Rüstfamilien zufällig ausgewählt und die Baugruppen-Zuordnungen zu diesen Festrüstungs-Rüstfamilien werden gelöscht. Alle anderen Baugruppentypen bleiben ihren Festrüstungs-Rüstfamilien fix zugeordnet.
(3) -> Dieses kleinere Rest-Problem wird nun mit dem MILP-Ansatz aus (1) gelöst.
(4) -> Schritt (2) und (3) wird wiederholt und insgesamt n-mal durchgeführt.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Die Implementierung der vorstehend beschriebenen Prozesse oder Verfahrensabläufe/-schritte kann anhand von Befehlen bzw. Instruktionen erfolgen, die auf computerlesbaren, nichtflüchtigen Speichermedien oder in flüchtigen Computerspeichern (im Folgenden zusammenfassend als computerlesbare Speicher bezeichnet) vorliegen. Computerlesbare Speicher sind beispielsweise flüchtige Speicher wie Caches, Puffer oder RAM sowie nichtflüchtige Speicher wie Wechseldatenträger, Festplatten, usw.

Die vorstehend beschriebenen Funktionen oder Schritte können dabei in Form zumindest eines Instruktionssatzes in/auf einem computerlesbaren Speicher vorliegen. Die Funktionen oder Schritte sind dabei nicht an einen bestimmten Instruktionssatz oder an eine bestimmte Form von Instruktionssätzen oder an ein bestimmtes Speichermedium oder an einen bestimmten Prozessor oder an bestimmte Ausführungsschemata gebunden und können durch Software, Firmware, Microcode, Hardware, Prozessoren, integrierte Schaltungen usw. im Alleinbetrieb oder in beliebiger Kombination ausgeführt werden. Dabei können verschiedenste Verarbeitungsstrategien zum Einsatz kommen, beispielsweise serielle Verarbeitung durch einen einzelnen Prozessor oder Multiprocessing oder Multitasking oder Parallelverarbeitung usw.

Die Instruktionen können in lokalen Speichern abgelegt sein, es ist aber auch möglich, die Instruktionen auf einem entfernten System z.B. Cloud abzulegen und darauf via Netzwerk zuzugreifen.

Unter "rechner-/computergestützt" bzw. "computerimplementiert" kann im Zusammenhang mit der Erfindung beispielsweise eine Implementierung des Verfahrens verstanden werden, bei dem insbesondere ein Prozessor bzw. eine Recheneinheit, der Teil der (Steuerungs- bzw. Verarbeitungs-)vorrichtung bzw. -einheit und/oder eines Computers und/oder eines oder mehrerer Dienste in einer Rechnerwolke (Cloud) eines Diensterbringers sein kann, mindestens einen Verfahrensschritt des Verfahrens ausführt.

Sofern es in der nachfolgenden Beschreibung nicht anders angegeben ist, beziehen sich die Begriffe "abbilden", "nachbilden", "empfangen", "anwenden", "ausgeben", "bereitstellen" und dergleichen vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt oder vorliegen können.

Der Begriff "Prozessor", "zentrale Signalverarbeitung", "Steuereinheit" oder "Datenauswertemittel", wie hier verwendet, umfasst Verarbeitungsmittel im weitesten Sinne, also beispielsweise Server, Universalprozessoren, Grafikprozessoren, digitale Signalprozessoren, anwendungsspezifische integrierte Schaltungen (ASICs), programmierbare Logikschaltungen wie FPGAs, diskrete analoge oder digitale Schaltungen und beliebige Kombinationen davon, einschließlich aller anderen dem Fachmann bekannten oder in Zukunft entwickelten Verarbeitungsmittel. Prozessoren können dabei aus einer oder mehreren Systemen bzw. Vorrichtungen bzw. Einrichtungen bzw. Einheiten bestehen. Besteht ein Prozessor aus mehreren Vorrichtungen, können diese zur parallelen oder sequentiellen Verarbeitung bzw. Ausführung von Instruktionen ausgelegt bzw. konfiguriert sein. Unter einer "Speichereinheit" kann im Zusammenhang mit der Erfindung beispielsweise ein computerlesbares Speichermedium in Form von Arbeitsspeicher (engl. Random-Access Memory, RAM) oder eine Festplatte verstanden werden.

## Patentansprüche

1. Computer-implementiertes Verfahren zur Bestimmung mindestens einer Festrüstungs-Rüstfamilie von Leiterplattentypen (122) für eine vorgegebene Anzahl mehrerer Gruppen von einer oder mehreren Bestückungslinien (110), wobei eine Festrüstung (165) eine Menge an Bauelementtypen (160) umfasst, die zur Bestückung von Leiterplatten (120) einer der bestimmten Festrüstungs-Rüstfamilien von Leiterplattentypen ausreicht, wobei jede Festrüstung einer Festrüstungs-Rüstfamilie zugeordnet wird und während eines eine vorgegebene Anzahl von Bestückungsaufträgen umfassenden, vorgegebenen Planungshorizonts unverändert bleibt, und wobei jede Festrüstung an einer Bestückungslinie einer Gruppe eingesetzt wird, wobei das Verfahren folgende Schritte umfasst:

    a) Erfassen von Bestückungsaufträgen, welche jeweils eine Stückzahl von Leiterplatten eines Leiterplattentyps umfassen, wobei die Leiterplatten auf den einen oder mehreren Bestückungslinien innerhalb des Planungshorizont bestückt werden sollen, wobei jede Bestückungslinie zu einer Gruppe gehört;
    b) Zuordnen von Leiterplattentypen der erfassten Bestückungsaufträge an eine Festrüstungs-Rüstfamilie, wobei Leiterplattentypen einer vorgegebenen Menge an Leiterplattentypen nur einer oder mehreren bestimmten Festrüstungs-Rüstfamilien zugeordnet werden dürfen, deren Festrüstungen an einer oder mehreren Bestückungslinien lediglich einer Gruppe eingesetzt werden, mit dem Zweck, Leiterplatten aller zugeordneten Leiterplattentypen jeweils mit Hilfe der an den Bestückungslinien eingesetzten Festrüstungen, die zu den jeweiligen zugeordneten Festrüstungs-Rüstfamilien gehören, zu bestücken;

c) Optimieren der Zuordnung aus Schritt b) derart, dass eine auf alle Gruppen bezogene Kennzahl optimiert, insbesondere maximiert, wird; und

d) Ausgeben der mittels der optimierten Zuordnung bestimmten Festrüstungs-Rüstfamilien in einer zur Steuerung und/oder zur Regelung der Bestückungsauftragserfüllung geeigneten Form.

2. Verfahren nach dem vorhergehenden Anspruch, **dadurch gekennzeichnet, dass** die Bestimmung mindestens einer Festrüstungs-Rüstfamilie von Leiterplattentypen mit den Schritten a) bis d) zentral auf einem Datenverarbeitungssystem (DS) ausgeführt wird.

3. Verfahren nach einem der vorhergehenden Ansprüche, **dadurch gekennzeichnet, dass** die Bestückung von Leiterplatten anhand der bestimmten Festrüstungs-Rüstfamilien in genannter Form und der damit zugeordneten Festrüstungen jeweils innerhalb einer Gruppe von einer oder mehreren Bestückungslinien gesteuert und/oder geregelt und/oder zur Ausführung gebracht wird.

4. Verfahren nach einem der vorhergehenden Ansprüche, **dadurch gekennzeichnet, dass** jede Gruppe mit einer vorgegebenen Anzahl von Bestückungslinien in einer Produktionsstätte von einer vorgegebenen Anzahl von unterschiedlichen Produktionsstätten (P1, P2, P3) angeordnet ist.

5. Verfahren nach einem der vorhergehenden Ansprüche, **dadurch gekennzeichnet, dass** die Kennzahl eine Anzahl an Bestückungsaufträgen ausdrückt, deren Leiterplattentypen einer Festrüstungs-Rüstfamilie zugeordnet werden.

6. Verfahren nach einem der vorhergehenden Ansprüche, **dadurch gekennzeichnet, dass** ein Wert erfasst wird, der einen Verlagerungsaufwand für den Transport einer oder mehrerer Leiterplatten eines Leiterplattentyps und/oder mehrerer für die Bestückung derselben notwendigen Bauelemente von einer Bestückungslinie einer Gruppe zu einer Bestückungslinie einer anderen Gruppe ausdrückt, wenn der Leiterplattentyp einer Festrüstungs-Rüstfamilie der anderen Gruppe zugeordnet werden soll.

7. Verfahren nach dem vorhergehenden Anspruch, **dadurch gekennzeichnet, dass** die Kennzahl aus einer gewichteten Kombination der Anzahl an Bestückungsaufträgen sowie aus einem Gesamtwert über die Werte der Verlagerungsaufwände, die sich aus dem Zuordnen der Leiterplattentypen ergeben, berechnet wird.

8. Verfahren nach einem der vorhergehenden Ansprüche 6 oder 7, **dadurch gekennzeichnet, dass** die Kennzahl aus einer gewichteten Kombination der Anzahl an Bestückungsaufträgen sowie aus dem Gesamtwert über die Werte der Verlagerungsaufwände und aus einer Gesamtproduktionszeit der zugeordneten Leiterplattentypen berechnet wird, die sich aus erfassten Produktionszeiten für die Bestückung jeder Leiterplatte eines Leiterplattentyps auf einer Bestückungslinie einer Gruppe ergibt.

9. Verfahren nach einem der vorhergehenden Ansprüche, **dadurch gekennzeichnet, dass** die Optimierung mittels Gemischt Ganzzahliger Programmierung erfolgt.

10. Datenverarbeitungssystem (DS) umfassend mindestens eine Recheneinheit, die dazu konfiguriert ist, ein computer-implementiertes Verfahren zur Bestimmung mindestens einer Festrüstungs-Rüstfamilie von Leiterplattentypen (122) für eine vorgegebene Anzahl mehrerer Gruppen von einer oder mehreren Bestückungslinien (110) auszuführen, wobei eine Festrüstung (165) eine Menge an Bauelementtypen (160) umfasst, die zur Bestückung von Leiterplatten (120) einer der bestimmten Festrüstungs-Rüstfamilien von Leiterplattentypen ausreicht, wobei jede Festrüstung einer Festrüstungs-Rüstfamilie zugeordnet wird und während eines eine vorgegebene Anzahl von Bestückungsaufträgen umfassenden, vorgegebenen Planungshorizonts unverändert bleibt, und wobei jede Festrüstung an einer Bestückungslinie einer Gruppe eingesetzt wird, umfassend zumindest:

a) eine Erfassungseinheit zum Erfassen von Bestückungsaufträgen, welche jeweils eine Stückzahl von Leiterplatten eines Leiterplattentyps umfassen, wobei die Leiterplatten auf den einen oder mehreren Bestückungslinien innerhalb des Planungshorizont bestückt werden sollen, wobei jede Bestückungslinie zu einer Gruppe gehört;

b) eine Zuordnungseinheit von Leiterplattentypen der erfassten Bestückungsaufträge an eine Festrüstungs-Rüstfamilie, wobei Leiterplattentypen einer vorgegebenen Menge an Leiterplattentypen nur einer oder mehreren bestimmten Festrüstungs-Rüstfamilien zugeordnet werden dürfen, deren Festrüstungen an einer oder mehreren Bestückungslinien lediglich einer Gruppe eingesetzt werden, mit dem Zweck, Leiterplatten aller zugeordneten Leiterplattentypen jeweils mit Hilfe der an den Bestückungslinien eingesetzten Festrüstungen, die zu den jeweiligen zugeordneten Festrüstungs-Rüstfamilien gehören, zu bestücken;

c) eine Optimierungseinheit zum Optimieren der Zuordnung derart, dass eine auf alle Gruppen bezogene Kennzahl optimiert, insbesondere maximiert, wird; und

d) eine Ausgabeeinheit zum Ausgeben der mittels der optimierten Zuordnung bestimmten Festrüstungs-Rüstfamilien in einer zur Steuerung und/oder zur Regelung der Bestückungsauftragserfüllung geeigneten Form.

11. Steuerungsvorrichtung (115), umfassend wenigstens

- eine Empfangseinheit zum Empfangen von mittels optimierter Leiterplattentypen-Zuordnung bestimmten Festrüstungs-Rüstfamilien in einer zur Steuerung und/oder zur Regelung der Bestückungsauftragserfüllung geeigneten Form und

- eine Recheneinheit zum Verteilen der Leiterplattentypen auf eine oder mehrere Bestückungslinien anhand der bestimmten Festrüstungs-Rüstfamilien, wobei Leiterplattentypen einer vorgegebenen Menge an Leiterplattentypen nur einer oder mehreren bestimmten Festrüstungs-Rüstfamilien zugeordnet werden dürfen, deren Festrüstungen an einer oder mehreren Bestückungslinien lediglich einer Gruppe eingesetzt werden, mit dem Zweck, Leiterplatten aller zugeordneten Leiterplattentypen jeweils mit Hilfe der an den Bestückungslinien eingesetzten Festrüstungen, die zu den jeweiligen zugeordneten Festrüstungs-Rüstfamilien gehören, zu bestücken.

12. Anordnung umfassend mehrere Gruppen von einer oder mehreren Bestückungslinien (110), ein Datenverarbeitungssystem nach Anspruch 10 und eine Steuerungsvorrichtung gemäß Anspruch 11.

13. Computerprogrammprodukt umfassend einen durch eine Recheneinheit ausführbaren Programmkode oder mehrere durch mehrere Recheneinheiten ausführbare und zusammenwirkende Programmkodemodule, welches oder welche Befehle aufweisen, die die Ausführung des Verfahrens nach einem der vorhergehenden Verfahrensansprüche auf dem Datenverarbeitungssystem nach Anspruch 10 oder in der Anordnung nach Anspruch 12 veranlassen.

14. Computerlesbarer Datenträger oder Datenträgersignal umfassend das Computerprogrammprodukt nach dem vorhergehenden Anspruch.

## FIG 1

FIG 2

FIG 3

Europäisches Patentamt

European Patent Office

Office européen des brevets

**EUROPÄISCHER RECHERCHENBERICHT**

Nummer der Anmeldung

**EP 22 15 5915**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2014 225713 A1 (SIEMENS AG [DE]) 16. Juni 2016 (2016-06-16) * Absätze [0008] – [0018], [0035] – [0038], [0045] – [0050]; Anspruch 2; Abbildungen 1-3 * ----- | 1-14 | INV. H05K13/08 |

RECHERCHIERTE SACHGEBIETE (IPC)

H05K

Der vorliegende Recherchenbericht wurde für alle Patentansprüche erstellt

| Recherchenort | Abschlußdatum der Recherche | Prüfer |
|---|---|---|
| Den Haag | 20. Juli 2022 | Shaalan, Mohamed |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 22 15 5915

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

20-07-2022

| Im Recherchenbericht angeführtes Patentdokument | Datum der Veröffentlichung | Mitglied(er) der Patentfamilie | Datum der Veröffentlichung |
|---|---|---|---|
| DE 102014225713 A1 | 16-06-2016 | CN 107006149 A | 01-08-2017 |
| | | DE 102014225713 A1 | 16-06-2016 |
| | | EP 3207778 A1 | 23-08-2017 |
| | | JP 6370495 B2 | 08-08-2018 |
| | | JP 2018500761 A | 11-01-2018 |
| | | US 2018324991 A1 | 08-11-2018 |
| | | WO 2016091527 A1 | 16-06-2016 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2893791 B1

- EP 3219180 B1